# FASCICULE DE BREVET EUROPEEN

(11) **EP 4 202 936 B1**
(45) Date de publication et mention de la délivrance du brevet: **27.08.2025**
(21) Numéro de dépôt: 22213321.7
(22) Date de dépôt: 14.12.2022
(51) Int. Cl.: G11C 13/00

(54) **PROCÉDÉ D'ÉCRITURE POUR DES MÉMOIRES RÉSISTIVES DIFFÉRENTIELLES**
SCHREIBVERFAHREN FÜR DIFFERENTIELLE RESISTIVE SPEICHER
WRITING METHOD FOR DIFFERENTIAL RESISTIVE MEMORIES

(30) Priorité: 23.12.2021 FR 2114324
(43) Date de publication de la demande: 28.06.2023
(73) Titulaire: Commissariat à l'Energie Atomique et aux Energies Alternatives, 75015 Paris (FR); Weebit Nano Ltd, 4513001 Hod-Hasharon (IL)
(72) Inventeur: GIRAUD, Bastien, 38054 Grenoble Cedex 09 (FR); LAFFOND, Cyrille, 38054 Grenoble Cedex 09 (FR); RICAVY, Sébastien, 38054 Grenoble Cedex 09 (FR); GHERMAN, Valentin, 38054 Grenoble Cedex 09 (FR); SEVER, Ilan, 4020101 Kfar Vitkin (IL)
(74) Mandataire: Atout PI Laplace

(56) Documents cités:
- WO-A1-2021/016237
- US-A1- 2019 333 579

## Description

### Domaine de l'invention

La présente invention concerne un procédé d'écriture pour des mémoires résistives différentielles, de structure 2T2R.

### Etat de la technique

Les mémoires résistives sont des mémoires non-volatiles présentant une vitesse de fonctionnement plus élevée que la NAND flash (mémoire SSD), une faible consommation d'énergie électrique et une grande durée de vie. Pour ces raisons, les mémoires résistives sont des candidates prometteuses pour remplacer à la fois les mémoires vives et les mémoires non-volatiles actuelles telles que les mémoires de type flash.

Il existe plusieurs technologies de mémoires résistives. On peut notamment citer les mémoires résistives à pont conducteur, également appelées CBRAM (pour « Conductive-Bridging Random-Access Memory » selon la terminologie anglo-saxonne), ou les mémoires résistives à base d'oxyde, également appelées OxRAM (pour « Oxide-based Random-Access Memory » selon la terminologie anglo-saxonne) ou encore les mémoires à changement de phase, également appelées PCM (pour « Phase Change Memory »).

Une mémoire résistive est composée d'une multitude de cellules mémoires résistives agencées en lignes et colonnes de manière à former une matrice. Une cellule mémoire RRAM est dotée d'au moins un élément résistif dont on peut modifier la résistance électrique.

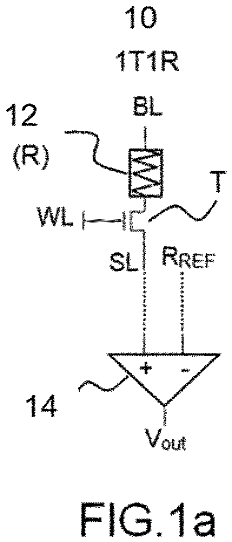

Une cellule mémoire résistive élémentaire telle qu'illustrée sur la figure 1a (avec un exemple de dispositif de lecture associé), est constituée généralement d'un transistor (T) et d'un composant résistif (R) ou résistor (12), où un bit d'information est encodé par la valeur de la résistance électrique du résistor et accédé via le transistor au croisement d'une ligne de bit (BL) et d'une ligne de mot (WL). Pour ces cellules élémentaires, un '0' logique peut par exemple être encodé en programmant le résistor dans un état de résistance haute HRS, et un '1' logique peut alors être encodé en programmant le résistor dans un état de résistance basse LRS, et l'on parle alors d'encodage en mode 1T1R.

Pour programmer une cellule mémoire, une tension de programmation est appliquée entre les électrodes de la cellule mémoire. Il peut s'agir d'une tension d'écriture pour écrire la cellule mémoire, c'est-à-dire la placer dans l'état faiblement résistif LRS, ou d'une tension d'effacement pour effacer la cellule mémoire, c'est-à-dire la placer dans l'état fortement résistif HRS. Cependant, après une opération de programmation, il peut arriver que la cellule mémoire ne passe pas dans l'état de résistance souhaité. Pour cette raison, il est généralement effectué une vérification pour s'assurer que la cellule mémoire est correctement programmée en comparant sa valeur de résistance R à un seuil de résistance prédéfini R_{REF}.

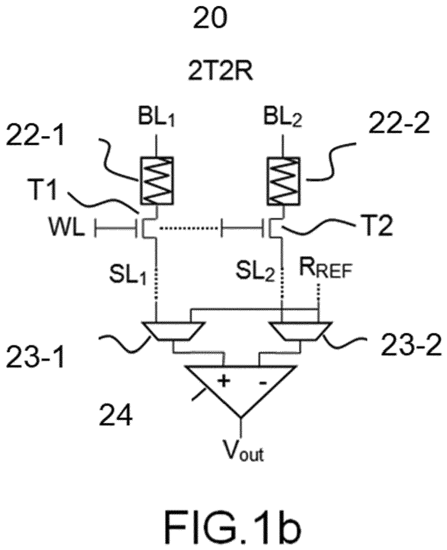

Cependant, l'écart entre la plus faible valeur correspondant à un niveau HRS et la plus haute valeur correspondant au niveau LRS, également appelé « fenêtre mémoire », est souvent faible. Dès lors, on utilise couramment un « encodage différentiel » pour coder une valeur binaire à mémoriser. Un bit d'information peut alors être encodé dans une cellule mémoire dite 2T2R, composée de deux cellules élémentaires 1T1R, comprenant 2 transistors (2T) et 2 résistors (2R), et l'on parle alors d'encodage en mode 2T2R. La figure 1b illustre une variante d'implémentation d'une cellule 2T2R avec un dispositif de lecture d'une telle cellule mémoire.

Comme chacun des états HRS et LRS peut être associé à une valeur logique, i.e. '0' ou '1', on peut considérer que dans une cellule 2T2R un des deux éléments résistifs encode le bit à programmer en version non-inversée tandis que l'autre élément résistif encode le même bit en version inversée. Par exemple, un '0' logique est encodé en programmant le résistor de la première cellule 1T1R dans un état de résistance haute HRS et le résistor de la deuxième cellule 1T1R dans un état de résistance basse LRS, et un '1' logique est encodé en programmant le résistor de la première cellule 1T1R dans un état de résistance basse LRS et le résistor de la deuxième cellule dans un état de résistance haute HRS.

Ainsi, en encodage différentiel, chaque bit d'information est encodé dans une cellule élémentaire 2T2R formée de deux éléments résistifs qui sont écrits en opposition d'état, c'est-à-dire un des éléments résistifs avec un niveau HRS et l'autre avec un niveau LRS, les niveaux respectifs de résistance des deux éléments résistifs étant déterminés toujours dans le même ordre entre les deux éléments, qui définissent si l'on est en présence d'un '0' ou d'un '1' logique suivant qu'il correspond aux états HRS-LRS ou LRS-HRS.

Lors d'une opération d'écriture dans une cellule mémoire 1T1R ou 2T2R, il faut s'assurer que chaque résistance électrique qui doit être programmée à un état HRS ou l'état LRS est respectivement soit plus grande, soit plus petite qu'une valeur de référence R_{REF}. La comparaison d'une résistance électrique avec la valeur R_{REF} est faite par une opération de lecture au cours de laquelle la résistance programmée est comparée à la valeur R_{REF} à l'aide d'un amplificateur de détection ou SA (pour « Sense Amplifier» selon la terminologie anglo-saxonne) illustré par le composant 14 sur la figure 1a, 24 sur la figure 1b, et 34 sur la figure 1c. Par la suite, cette opération de lecture avec comparaison à une valeur de référence est appelée mode 1T1R.

Sur la figure 1a, l'amplificateur de détection 14 réagit à la différence de ses deux entrées 'SL' (provenant de la cellule 1T1R) et 'ref' (représentative d'une valeur de résistance électrique de référence R_{REF}), pour générer un signal de sortie 'Vₒᵤₜ' qui indique l'état résistif de l'élément mémoire de la cellule et renseignant ainsi la valeur qui est stockée dans la cellule 1T1R.

Sur la figure 1b, l'amplificateur de détection 24 est sensible à la différence sur ses entrées, pour générer un signal de sortie 'Vₒᵤₜ'. Deux multiplexeurs (23-1, 23-2) sont respectivement reliés, sur une première entrée, à chaque ligne SL (SL1, SL2) reliée à une cellule 1T1R (22-1, 22-2). La seconde entrée de chaque multiplexeur est reliée à une résistance de référence R_{REF}. Les sorties des multiplexeurs sont respectivement reliées aux entrées de l'amplificateur différentiel de détection 24. Ce schéma est très symbolique et ne représente pas l'ensemble des éléments électroniques nécessaires à la réalisation d'une opération de lecture qui sont bien connus de l'homme de l'art (notamment les circuits de polarisation des cellules élémentaires et de la résistance de référence). Ce schéma simplifié permet d'illustrer plusieurs principes de lecture possibles pour des cellules différentielles. Ainsi, quand les deux multiplexeurs sont configurés pour laisser passer les signaux présents sur les lignes SL1 et SL2, l'amplificateur 24 évalue une différence de résistance des deux éléments résistifs de la cellule 2T2R (respectivement, la différence entre 22-1 et 22-2), en renseignant ainsi sur la valeur qui est stockée dans la paire différentielle sélectionnée de la cellule 2T2R. Quand on souhaite réaliser une lecture d'une unique cellule 1T1R, et se ramener au mode de lecture représenté en figure 1a, les multiplexeurs sont positionnés de sorte à laisser passer une ligne SL1 ou SL2 sur l'un des multiplexeurs et à laisser passer le signal relié à la résistance de référence sur l'autre des multiplexeurs.

Les opérations de lecture dans les mémoires résistives sont généralement effectuées en mode 1T1R. Pour lire les données de la cellule RRAM, une petite tension de lecture qui ne perturbe pas l'état courant de la cellule est appliquée pour déterminer dans quel état logique est la cellule.

Dans les mémoires où l'information est encodée en mode 2T2R, les opérations de lecture, hors celle de vérification de la programmation, peuvent être effectuées en mode 2T2R aussi appelé lecture en mode différentiel. Les valeurs des deux résistances présentes dans chaque cellule mémoire 2T2R qui est adressée, sont comparées entre elles à l'aide d'un amplificateur de détection SA.

Une technique de lecture d'une donnée stockée dans une cellule mémoire 2T2R est décrite dans le document : « Hybrid Analog-Digital Learning with Differential RRAM synapses » de Bocquet et al. IEDM19-534. Elle utilise un circuit de lecture doté d'un amplificateur de détection de type à verrouillage qui, lors d'une opération de lecture, est couplé à la paire différentielle d'éléments résistifs par l'intermédiaire d'une paire de lignes de bits et est dotée de nœuds dont les potentiels basculent en fonction de valeurs de courant qui traversent les éléments résistifs. Ce type d'amplificateur de détection est réalisé avec peu de transistors et fonctionne comme un amplificateur différentiel de courant à fort gain. Il permet de comparer directement des courants qui traversent les éléments résistifs et circulent via des lignes de bits.

Étant donné que les éléments résistifs conservent leurs valeurs respectives même après la suppression de la tension appliquée, la mémoire résistive RRAM fait partie des mémoires non volatiles. Cependant, l'usage d'une mémoire implique de fréquentes transitions entre un état à haute résistance (HRS) et un état à faible résistance (LRS), et réciproquement, et chaque événement de commutation entre ces états résistifs peut introduire des dommages, les valeurs des résistances programmées pouvant changer à cause de phénomènes de relaxation, et entraîner alors une dégradation des performances de la RRAM.

Le temps de rétention de l'information dans une mémoire résistive dépend alors (a) des opérations de lecture et d'écriture, (b) des températures d'utilisation et/ou (c) des champs magnétiques élevés dans le cas des mémoires magnétiques.

De plus, les tensions de commutation sont aussi des paramètres présentant un degré élevé de variation. Les variations de la commutation de résistance comprennent des fluctuations temporelles (cycle à cycle) et des fluctuations spatiales (dispositif à dispositif).

Par ailleurs, les mémoires résistives présentent également une non-uniformité cellule à cellule qui dégrade également les performances de la mémoire en réduisant la marge de mémoire entre deux états. L'origine de cette variabilité est attribuée aux non-uniformités du processus de fabrication telles que l'épaisseur du film de commutation, les dommages de gravure et la rugosité de surface des électrodes.

Ces variations entrainent que les résistances des mémoires résistives qui sont programmées dans l'état LRS peuvent dériver vers un état HRS, et les résistances qui sont programmées dans l'état HRS peuvent dériver vers un état LRS. Dès lors, ce glissement des valeurs des résistances programmées peut engendrer des erreurs lors des opérations de lecture, et diminuer la performance des mémoires.

Une manière courante d'améliorer la performance des mémoires RRAM est de diminuer leur taux d'erreur. Pour réduire le taux d'erreur des mémoires, une solution couramment utilisée consiste à utiliser un code correcteur d'erreurs ou ECC (pour « Error Correcting Code » selon la terminologie anglo-saxonne) qui encode les données avant leur écriture en mémoire. Généralement, l'encodeur ECC est situé à l'intérieur ou à proximité du contrôleur mémoire. Lors de l'encodage de données avec un code ECC, des bits de vérification sont ajoutés aux bits de données, les bits de vérification représentant une information redondante calculée à partir des bits de données, qui permet la détection et la correction des erreurs affectant aussi bien les bits de données que les bits de vérification. L'ensemble des bits de données et des bits de vérification forme un mot de code.

L'utilisation de mémoires résistives 2T2R, qui présentent théoriquement une fenêtre de lecture deux fois plus grande, permet de réduire le taux d'erreurs et le besoin d'employer un code correcteur coûteux. L'efficacité de l'encodage différentiel est plus grande dans le cas où la programmation de chaque résistance utilisée pour un encodage différentiel est effectuée en mode 1T1R, c'est-à-dire dans un mode où il faut garantir que si la valeur de la résistance doit être en état HRS/LRS alors elle est bien plus grande/petite qu'une valeur de référence R_{REF}. Cependant cette dernière contrainte rend l'opération d'écriture d'une mémoire résistive plus difficile et plus longue.

Dans les mémoires résistives de type 2T2R, une opération d'écriture utilise significativement plus d'énergie qu'une opération de lecture et, de plus, elle affecte les performances des cellules de mémoires, bien plus que ne le fait une opération de lecture. Face à cette problématique de perte de performance il existe le besoin d'une solution pour éviter ou diminuer les opérations d'écriture dans des mémoires résistives de type 2T2R. WO 2021/016237 A1 et US 2019/333579 A1 divulguent des méthodes de programmation des mémoires résistives.

### Description brève de l'invention

L'invention vise à pallier tout ou partie des problèmes cités plus haut en proposant un procédé d'écriture pour des mémoires de types résistives de type 2T2R qui est moins contraignant et également plus rapide. Ce procédé d'écriture permet de garantir la fonctionnalité de la mémoire résistive malgré la variabilité intrinsèque des opérations d'écriture pour des mémoires résistives.

A cet effet, l'invention a pour objet un procédé d'écriture d'un mot de données dans une mémoire résistive composée de cellules différentielles 2T2R comprenant chacune des premier et deuxième ensembles d'un résistor (R) et d'un transistor de sélection (T), le procédé comprenant des étapes consistant à : générer un mot de code initial à partir de bits de données initiales et de bits de vérification générés à partir du mot de données, et initialiser un compteur de nombre de programmations, le nombre de programmations correspondant à un nombre maximum de programmations pour ledit mot dans un groupe de cellules différentielles sélectionnées ; programmer en mode 1T1R ce mot de code initial dans la mémoire résistive, en sélectionnant les premiers ensembles 1T1R des cellules différentielles sélectionnées, puis réaliser une lecture 1T1R de vérification et incrémenter ou décrémenter le compteur de nombre de programmations ; répéter l'étape précédente tant que tous les bits du mot de code initial n'ont pas été programmés correctement et que le nombre maximum de programmations n'est pas atteint ; inverser le mot de code initial et réinitialiser le compteur de nombre de programmations ; programmer en mode 1T1R dans la mémoire résistive, le mot de code initial inversé à l'étape précédente, en sélectionnant les deuxièmes ensembles 1T1R des cellules différentielles sélectionnées, puis réaliser une lecture 1T1R de vérification et incrémenter ou décrémenter le compteur de nombre de programmations ; répéter l'étape précédente tant que tous les bits du mot de code initial inversé n'ont pas été programmés correctement et que le nombre maximum de programmations n'est pas atteint ; réaliser une lecture de vérification en mode différentiel 2T2R des cellules différentielles sélectionnées et vérifier à minima que les données lues correspondent auxdites données initiales ; et selon le résultat de la vérification, terminer le procédé d'écriture ou signaler une erreur du procédé d'écriture.

Dans un mode de réalisation, ladite lecture de vérification en mode différentiel 2T2R inclut la vérification de tous les bits du mot de code lus par rapport aux bits du mot de code initial.

Dans un mode de réalisation, l'étape consistant à répéter l'étape précédente (programmer en mode 1T1R ce mot de code initial dans la mémoire résistive) comprend les sous-étapes suivantes consistant à : vérifier par lecture en mode 1T1R dans la mémoire résistive s'il reste des bits de données et de vérification non programmés ; et s'il reste des bits non programmés et si le nombre maximum d'écritures en mémoire pour ledit mot de code initial n'est pas atteint, répéter l'étape consistant à programmer en mode 1T1R ledit mot de code initial dans la mémoire résistive ; ou s'il ne reste pas de bits non programmés ou si le nombre maximum d'écritures en mémoire pour ledit mot de code initial est atteint, poursuivre par l'étape suivante.

Dans un mode de réalisation, l'étape consistant à répéter l'étape précédente (s'il reste des bits non programmés et si le nombre maximum d'écritures en mémoire pour ledit mot de code initial n'est pas atteint) comprend les sous-étapes suivantes consistant à : vérifier par lecture en mode 1T1R dans la mémoire résistive s'il reste des bits de données et de vérification du mot de code initial inversé non programmés ; et s'il reste des bits non programmés et si le nombre maximum d'écritures en mémoire pour ledit mot de code initial inversé n'est pas atteint, répéter l'étape consistant à programmer en mode 1T1R ledit mot de code initial inversé dans la mémoire résistive ; ou s'il ne reste pas de bits non programmés ou si le nombre maximum d'écritures en mémoire pour ledit mot de code initial inversé est atteint, poursuivre par l'étape suivante (réaliser une lecture de vérification en mode différentiel 2T2R des cellules différentielles sélectionnées et vérifier à minima que les données lues correspondent auxdites données initiales).

Dans un mode de réalisation, l'étape consistant à répéter l'étape précédente (programmer en mode 1T1R dans la mémoire résistive, le mot de code initial inversé à l'étape précédente) comprend les sous-étapes suivantes consistant à : vérifier par lecture en mode 1T1R dans la mémoire résistive s'il reste des bits de données et de vérification du mot de code initial inversé non programmés ; et s'il reste des bits non programmés et si le nombre maximum d'écritures en mémoire pour ledit mot de code initial inversé n'est pas atteint, répéter l'étape consistant à programmer en mode 1T1R ledit mot de code initial inversé dans la mémoire résistive ; ou s'il ne reste pas de bits non programmés ou si le nombre maximum d'écritures en mémoire pour ledit mot de code initial inversé est atteint, poursuivre par l'étape suivante (réaliser une lecture de vérification en mode différentiel 2T2R des cellules différentielles sélectionnées et vérifier à minima que les données lues correspondent auxdites données initiales).

Dans un mode de réalisation, l'étape consistant à terminer le procédé d'écriture est effectuée si les données lues en mode 2T2R correspondent auxdites données initiales; et dans lequel l'étape consistant à signaler une erreur du procédé d'écriture est effectuée si les données lues en mode 2T2R ne correspond pas auxdites données initiales.

Dans un mode de réalisation, l'étape consistant à programmer en mode 1T1R le mot de code initial dans la mémoire résistive et/ou l'étape consistant à programmer en mode 1T1R le mot de code initial inversé dans la mémoire résistive comprenant des sous-étapes consiste à : lire en mode 1T1R dans la mémoire résistive les bits à l'adresse de programmation du mot de code et comparer les bits lus à ladite adresse de programmation et les bits du mot de code à programmer, et programmer en mode 1T1R dans la mémoire résistive uniquement les bits du mot de code qui ne correspondent pas aux bits lus.

Dans un mode de réalisation, l'étape consistant à programmer en mode 1T1R le mot de code initial dans la mémoire résistive ou l'étape consistant à programmer en mode 1T1R le mot de code initial inversé dans la mémoire résistive sont effectuées par un unique circuit d'écriture adapté pour configurer dans un état HRS ou LRS les cellules de la mémoire résistive.

Dans un mode de réalisation, l'étape consistant à programmer en mode 1T1R le mot de code initial dans la mémoire résistive et/ou l'étape consistant à programmer en mode 1T1R le mot de code initial inversé dans la mémoire résistive sont effectuées par un premier circuit d'écriture uniquement adapté pour configurer dans un état HRS les cellules de la mémoire résistive et, en parallèle, par un second circuit d'écriture uniquement adapté pour configurer dans un état LRS les cellules de la mémoire résistive.

Dans un mode de réalisation, l'étape consistant à programmer en mode 1T1R le mot de code initial dans la mémoire résistive et/ou l'étape consistant à programmer en mode 1T1R le mot de code initial inversé dans la mémoire résistive sont effectuées premièrement par le premier circuit d'écriture concernant les cellules de la mémoire résistive à programmer dans un état HRS puis étant effectuée secondairement par le second circuit d'écriture concernant les cellules de la mémoire résistive à programmer dans un état LRS, ou inversement.

L'invention concerne également un système comprenant une mémoire résistive composée de cellules différentielles 2T2R comprenant chacune des premier et deuxième ensembles d'un résistor (R) et d'un transistor de sélection (T), et un dispositif d'écriture d'un mot de données dans la mémoire résistive, le dispositif comprenant des moyens pour mettre en œuvre les étapes du procédé d'écriture de l'invention.

Dans un mode de réalisation, les moyens du dispositif d'écriture d'un mot de données comprennent un contrôleur mémoire couplé à la mémoire résistive pour mettre en œuvre l'étape de lecture de vérification en mode différentiel 2T2R du procédé d'écriture de l'invention.

Dans un mode de réalisation, les moyens du dispositif d'écriture d'un mot de données comprennent un processeur hôte couplé à la mémoire résistive adapté pour mettre en œuvre l'étape de lecture de vérification en mode différentiel 2T2R du procédé de l'invention.

### Brève description des figures

D'autres caractéristiques, détails et avantages de l'invention ressortiront à la lecture de la description faite en référence au dessin annexé donné à titre d'exemple et qui représente :
La figure 1a et la figure 1b illustrent des implémentations respectivement d'une cellule mémoire 1T1R et d'une cellule mémoire 2T2R.
La figure 2 représente les étapes d'un procédé d'écriture d'un mot de données dans une mémoire résistive composée de cellules différentielles 2T2R selon un mode de réalisation de l'invention.
La figure 3 représente un mode de réalisation particulier de l'étape consistant à programmer en mode 1T1R un mot de code initial dans une mémoire résistive.
La figure 4 représente un système général permettant de mettre en œuvre les étapes d'un procédé d'écriture d'un mot de données dans une mémoire résistive composée de cellules différentielles 2T2R selon un mode de réalisation de l'invention.

### Description détaillée de l'invention

Une opération d'écriture dans des mémoires résistives de type 2T2R nécessite la programmation de deux résistances.

Une opération d'écriture dans une mémoire résistive 2T2R, telle que la mémoire résistive 2T2R 430 de la figure 1, permet un encodage différentiel qui peut être réalisé en programmant le mot de code en mode 1T1R une première fois tel qu'il a été généré, pour écrire dans les cellules « gauches » 22-1 et une deuxième fois de façon complémentaire pour écrire dans les cellules « droites » 22-2.

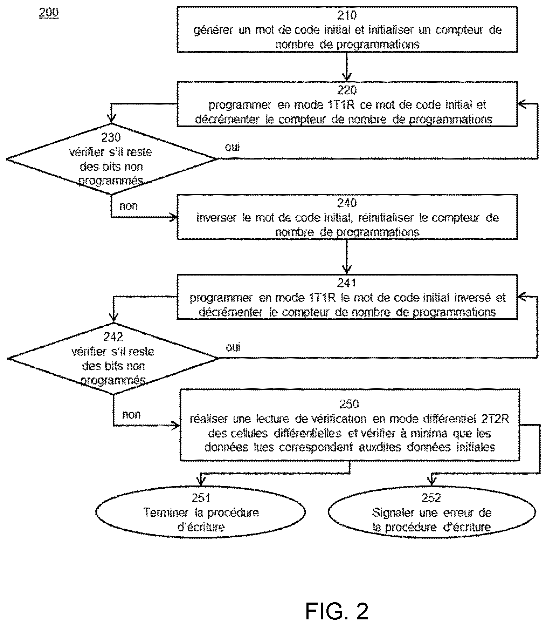

La figure 2 représente un procédé d'écriture 200 d'un mot de données dans une mémoire résistive de type 2T2R selon un mode de réalisation de l'invention. Lors de l'initiation du procédé d'écriture, les bits de données initiales qui doivent être écrits sont premièrement encodés par un encodeur ECC, pendant l'étape 210 de génération d'un mot de code initial. Egalement lors de cette étape 210, un compteur est initialisé avec un nombre de programmations maximum. Par exemple, le nombre maximum de programmations peut être de 10 unités, le compteur débutant à 10 et étant décrémenté d'une unité à chaque opération de programmation jusqu'à atteindre 0 auquel cas il n'y a plus de programmations disponibles. Alternativement, le nombre maximum de programmations peut être de 10 unités, le compteur débutant à 0 et étant incrémenté d'une unité à chaque opération jusqu'à atteindre 10 auquel cas il n'y a plus de programmations disponibles.

Le procédé d'écriture 200 se poursuit avec une étape 220 de programmation du mot de code initial dans la mémoire résistive selon un mode d'écriture 1T1R. En pratique, ce sont les cellules « gauches » de chaque cellule différentielle qui sont écrites en mode 1T1R. Cette étape 220 de programmation comprenant également la décrémentation du compteur de programmation. Le compteur de programmation est décrémenté ou incrémenté à chaque nouvelle étape de programmation de bits de données.

Après l'étape 220 de programmation, une étape 230 de lecture en mode 1T1R selon l'adresse du mot de code initial qui vient d'être programmé est effectuée. De même, ce sont les cellules « gauches » de chaque cellule différentielle qui sont lues en mode 1T1R. Ces deux étapes 220, 230, de programmation et de lecture correspondent à une opération généralement nommée WRITE/VERIFY, permettant de vérifier s'il reste encore des bits non-programmés d'un mot de code après sa programmation.

Dans le cas affirmatif, c'est-à-dire dans le cas où des bits de données et/ou de vérification n'ont pas été programmés, et si le nombre maximum d'écritures en mémoire selon le compteur de nombre de programmations pour ledit mot de code initial n'est pas encore atteint, l'étape 220 de programmation est réitérée (branche oui de 230). A chaque réitération d'une étape 220 de programmation, le nombre de programmations du compteur est uniquement incrémenté s'il a déjà été incrémenté lors de la première programmation. Alternativement, le nombre de programmations du compteur est décrémenté s'il a déjà été décrémenté lors de la première programmation.

Ce cycle d'étapes 220, 230, est effectué autant de fois que nécessaire jusqu'à ce que les bits de données et de vérification du mot de code initial soient tous programmés ou bien tant que le nombre maximum d'écritures en mémoire selon le compteur de nombre de programmations pour ledit mot de code initial n'est pas atteint.

Si tous les bits du mot de code initial ou si le nombre maximum d'écritures a été atteint (branche non de 230), le procédé poursuit avec l'étape suivante 240 d'inversion du mot de code initial et de réinitialisation du compteur du nombre de programmations.

Le procédé d'écriture 200 se poursuit avec une étape 240 d'inversion du mot de code initial, permettant d'obtenir un nouveau mot et de réinitialisation du compteur du nombre de programmations. Par inversion du mot de code initial, il est entendu que chaque bit de données et de vérification du mot de code initial est inversé, les valeurs logiques '1' devenant '0' et inversement.

Le procédé d'écriture 200 se poursuit ensuite avec une étape 241 de programmation des bits du mot de code initial inversé selon un mode d'écriture 1T1R. En pratique, ce sont cette fois-ci les cellules « droites » de chaque cellule différentielle qui sont écrites en mode 1T1R. Cette étape 241 de programmation comprend également la décrémentation du compteur de programmation. Après cette étape 241 de programmation, une étape 242 de lecture en mode 1T1R, à l'adresse mémoire qui vient d'être programmée, est effectuée. Là également, ce sont les cellules « droites » de chaque cellule différentielle qui sont lues en mode 1T1R. Ces deux étapes 241, 242, de programmation et de lecture et vérification correspondent également à une opération généralement nommée WRITE/VERIFY, permettant de vérifier s'il reste encore des bits non-programmés du mot de code initial inversé après sa programmation.

Lors de la programmation en mode 1T1R des bits de données et des bits de vérification du mot de code initial inversé (ou mot complémentaire) l'adresse de programmation est en général incrémentée de manière à correspondre à l'adresse complémentaire de chaque cellule de mémoire résistive 2T2R pour laquelle les bits de données et de vérification du mot de code initial ont dû être programmés lors de l'étape 220 de programmation (pour les cellules « gauches »). Ainsi, l'adresse complémentaire correspond aux résistances « droites » complémentaires des résistances « gauches » pour lesquelles la programmation a déjà été effectuée (ou tentée s'il y a eu une erreur de programmation).

Revenant à l'étape 242, dans le cas affirmatif où des bits de données et de vérification du mot de code initial inversé n'ont pas été programmés, et s'il reste des opérations de programmations disponibles, c'est-à-dire si le nombre maximum d'écritures en mémoire selon le compteur de nombre de programmations pour ledit mot de code initial inversé n'est pas encore atteint, l'étape 241 de programmation est réitérée (branche oui de 242).

Ce cycle d'étapes 241, 242, est effectué autant de fois que nécessaire jusqu'à ce que les bits du mot de code initial inversé soient tous programmés ou bien que le nombre maximum d'écritures en mémoire selon le compteur de nombre de programmations pour ledit mot de code initial inversé soit atteint, auxquels cas (branche non de 242) le procédé d'écriture se poursuit avec l'étape suivante 250 qui consiste en une opération de lecture de vérification en mode différentiel 2T2R des cellules différentielles sélectionnées et une opération de vérification à minima que les données lues correspondent auxdites données initiales. Par cette vérification, il est déterminé si la lecture différentielle en mode 2T2R des bits qui ont été programmés lors des étapes précédentes permet de lire des données qui correspondent aux données initiales pour lequel le procédé d'écriture a été effectué. Si les données lues en mode 2T2R correspondent aux données initiales, alors le procédé d'écriture peut être terminé 251. Si les données lues en mode 2T2R ne correspondent pas aux données initiales, alors une erreur du procédé d'écriture est signalée 252.

Avantageusement, l'étape 240 d'inversion du mot de code initial suivie de l'étape 241 de programmation en mode 1T1R du mot de code initial inversé sont effectuées sans aucune autre opération d'écriture et de vérification du mot de code initial qui a été programmé en mode 1T1R lors de l'étape précédente 220 de programmation du mot de code initial.

Le procédé d'écriture de la présente invention permet d'outrepasser des manquements ou des erreurs de programmation en mode 1T1R lors de la programmation d'un mot de code initial ou de ce mot de code initial sous une forme inversée. En effet, s'il est habituel dans le domaine technique des mémoires résistives de vérifier après chaque écriture la correcte programmation de bits de données et de vérification, il est aussi habituel de ne pas poursuivre de telles opérations d'écriture tant que tous les bits ne sont pas programmés. Ainsi, si dans le domaine une limitation du nombre maximal de programmations est déjà connue, ce nombre maximal de programmations est déterminé de manière à s'assurer d'une fiabilité suffisante de la programmation en mode 1T1R et donc d'un nombre de cycles de programmation suffisant.

Les inventeurs ont établi que le procédé d'écriture d'un mot de code dans une mémoire résistive composée de cellules 2T2R de la présente invention peut s'affranchir au moins partiellement de ce niveau de fiabilité de la programmation en mode 1T1R exigé dans l'art. En effet, le procédé de la présente invention se repose sur le doublement de la marge de lecture lorsque cette lecture est effectuée en mode différentiel, ce qui permet de réduire la répétition des procédures d'écriture tout en maintenant un niveau suffisant de fiabilité. Autrement dit, le nombre maximal d'itérations d'écriture en mode 1T1R est dans la présente invention choisi plus faible que le nombre maximal d'itérations d'écriture en mode 1T1R généralement retenu dans les dispositifs de l'état de l'art.

Ainsi le procédé d'écriture de la présente invention permet de maximiser les chances de bonne lecture d'un mot de code alors que le nombre maximal de programmations est diminué. Par conséquent, le procédé d'écriture de la présente invention permet d'optimiser la performance et la fiabilité d'une mémoire résistive en mode 2T2R en allant à l'encontre d'une recherche de la fiabilité des programmations effectuées en mode 1T1R.

Dans un cas particulier concernant l'écriture pour des mémoires résistives en mode 2T2R où le procédé d'écriture 200 n'implique pas l'écriture de bits de données constituant un mot entier mais seulement une subdivision de ce mot entier, il est nécessaire au préalable d'effectuer une lecture du mot entier à l'adresse mémoire ciblée par l'opération d'écriture 200, de corriger les éventuelles erreurs de stockage ou lecture à l'aide du décodeur ECC et d'inclure dans le mot entier éventuellement corrigé, la subdivision du mot à écrire. Le procédé d'écriture 200 pourra alors être effectué selon la première étape 210 de génération d'un mot de code à partir des bits de données correspondant au mot corrigé et modifié.

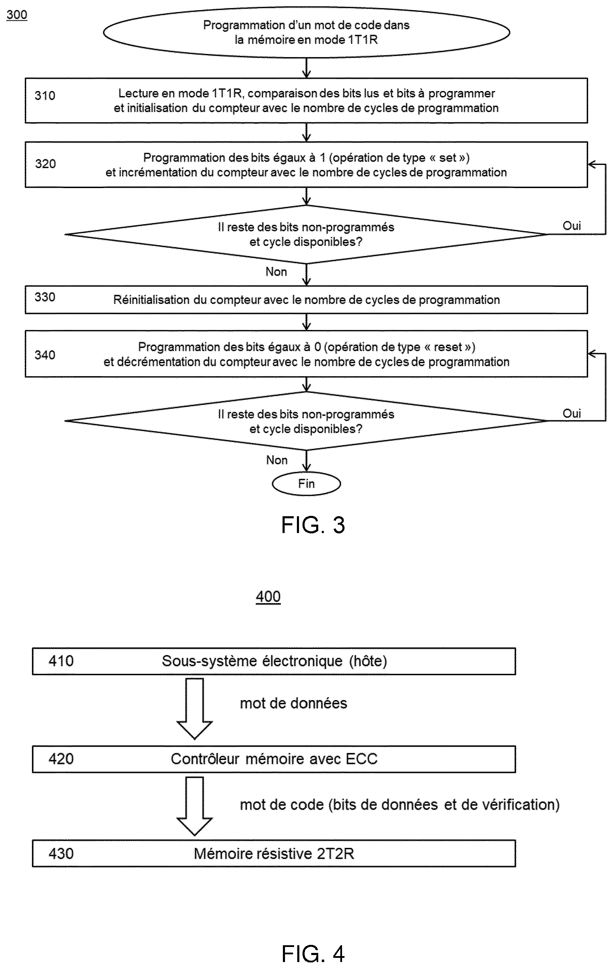

La figure 3 représente un mode de réalisation particulier d'un procédé 300 consistant à programmer en mode 1T1R un mot dans une mémoire résistive. Le procédé de programmation 300 d'un mot dans la mémoire 1T1R peut être appliqué pour l'étape présentée 220 de la figure 2, de programmation des bits du mot de code initial généré dans la mémoire résistive selon un mode 1T1R et aussi pour l'étape 241 de programmation des bits du mot de code initial inversé, dans la mémoire résistive et selon un mode 1T1R.

La programmation d'un mot dans la mémoire en mode 1T1R selon la figure 3 débute par une étape 310 consistant à lire en mode 1T1R dans la mémoire résistive les bits à l'adresse de programmation et comparer les bits lus à ladite adresse de programmation et les bits du mot à programmer. Grâce à cette comparaison, il est possible de déterminer quels sont les bits lus qui sont déjà programmés correctement pour le mot qui doit être programmé et lesquels ne sont pas programmés correctement.

Suite à cette étape 310, la programmation 300 se poursuit par une étape 320 consistant à programmer en mode 1T1R dans la mémoire résistive uniquement les bits qui ne correspondent pas aux bits du mot à programmer. Notamment, dans le mode de réalisation particulier de la figure 3, seuls sont programmés les bits qui n'étaient pas égaux à '1' et les bits qui étaient déjà programmés à '1' ne sont pas programmés. Cette étape est également connue comme une opération de type « set ». Egalement, lors de cette programmation le compteur de nombre de programmations est décrémenté.

Cette étape 310, de lecture puis programmation des bits seulement égaux à '1', correspondent à une étape connue selon l'anglicisme « READ BEFORE WRITE » qui permet d'économiser la programmation de cellules qui n'ont pas besoin d'être programmées.

La programmation d'un mot de code dans la mémoire en mode 1T1R selon la figure 3 se poursuit par une étape consistant à vérifier par lecture en mode 1T1R à l'adresse de programmation dans la mémoire résistive s'il reste des bits non programmés à '1'. Cette étape correspond aux étapes 230 et 242 de la figure 2.

La programmation d'un mot dans la mémoire en mode 1T1R selon la figure 3 se poursuit par une étape 340 consistant à programmer en mode 1T1R dans la mémoire résistive les bits du mot de code égaux à '0' qui ne correspondent pas aux bits lus. Notamment, dans le mode de réalisation particulier de la figure 3, les bits de données qui étaient déjà programmés à '0' ne sont pas modifiés. Cette étape est également connue comme une opération de type « reset ». Egalement, lors de cette programmation le compteur de nombre de programmations est décrémenté.

La programmation d'un mot de code dans la mémoire en mode 1T1R selon la figure 3 se poursuit par une étape consistant à vérifier par lecture en mode 1T1R à l'adresse de programmation dans la mémoire résistive s'il reste des bits non programmés à '0'. Cette étape correspond également aux étapes 230 et 242 de la figure 2, qui sont ainsi doublées, une étape étant effectuée pour chaque opération, une de type « set » et une de type « reset ».

Un mode de réalisation particulier d'un procédé d'écriture selon la présente invention consiste à effectuer le procédé d'écriture représenté par la figure 2, les étapes 220 et 241 de programmation en mode 1T1R dans la mémoire résistive étant effectuée selon la figure 3, ce mode de réalisation particulier ne comprenant pas d'étape de vérification de bits non-programmés effectuée juste après l'étape 320 de programmation de bits égaux à 1, et/ou d'étape de vérification de bits non-programmés effectuée juste après l'étape 340 de programmation de bits égaux à 0.

Dans un autre mode de réalisation particulier de l'invention qui peut être combiné aux modes de réalisation précédemment décrits, le dispositif mettant en œuvre le procédé d'écriture 300 dans une mémoire résistive en mode 1T1R comprend un premier circuit d'écriture uniquement adapté pour configurer dans un état HRS les cellules de la mémoire résistive et un second circuit d'écriture uniquement adapté pour configurer dans un état LRS les cellules de la mémoire résistive. Dans ce mode de réalisation particulier, l'étape 320 consistant à programmer des bits égaux à 1 (opération de type « set » utilisée pour programmer les cellules en état LRS) et l'étape 340 consistant à programmer des bits égaux à 0 (opération de type « reset » utilisée pour programmer les cellules en état HRS) sont effectuées en parallèle, c'est-à-dire en même temps par le premier circuit d'écriture concernant les cellules de la mémoire résistive à programmer dans un état HRS et par le second circuit d'écriture concernant les cellules de la mémoire résistive à programmer dans un état LRS. Un tel mode de réalisation permet notamment un gain de temps d'écriture, la programmation de bits de données pouvant être faite par deux circuits d'écriture en même temps lors de chaque étape de programmation.

Dans un autre mode de réalisation particulier de l'invention, le dispositif mettant en œuvre le procédé d'écriture 200 dans une mémoire résistive composée de cellules différentielles 2T2R comprend un unique circuit d'écriture adapté pour configurer dans un état HRS ou LRS les cellules de la mémoire résistive. En comparaison avec les modes de réalisation où le dispositif mettant en œuvre le procédé d'écriture 200 de l'invention comprend deux circuits d'écriture, un dispositif comportant un unique circuit d'écriture permet un gain de surface et une réduction de la consommation statique dans la réalisation de ce dispositif. On notera que ce circuit d'écriture « unique » car capable de programmer des « 0 » et des « 1 » est en pratique souvent constitué de plusieurs circuits d'écriture associés par exemple à des colonnes de cellules mémoire différentes, afin de pouvoir réaliser en parallèle plusieurs opérations d'écriture dans des cellules mémoires distinctes.

Par ailleurs, on notera que l'écriture des cellules mémoire associées à un mot de code est, de façon classique en soi, réalisées dans un groupe de cellules mémoires sélectionnées à partir d'une même valeur d'adresse qui est fournie par le processeur hôte, le nombre de cellules mémoires sélectionnées étant par exemple égal à k+r (k étant la taille des données et r le nombre de bits d'ECC). Ainsi, lorsque l'on réalise une lecture, en mode différentielle «2T2R » à une adresse indiquée par le processeur, on réalise en pratique une pluralité de lectures différentielles en parallèles des cellules mémoire associées à l'adresse indiquée.

Certains types de dispositifs mémoire peuvent être configurés pour la mémorisation des données en cellules « single » ou cellules « différentielles », avec la possibilité de doubler la taille de la mémoire si les données sont mémorisées en single. Ainsi, la plage d'adresses prévues pour ce type de mémoire est celle correspondant au maximum d'espace de stockage, en configuration de mémorisation 1T1R, en pratique cela correspond à un espace d'adressage double de celui nécessaire pour une mémoire fonctionnant uniquement en mode de mémorisation 2T2R. Lorsqu'un tel dispositif double mode de mémorisation est configuré en mode de mémorisation 1T1R, alors les écritures et les lectures sont toutes, toujours, réalisées en mode de lecture 1T1R et bien entendu en mode d'écriture 1T1R uniquement. C'est seulement quand un tel dispositif mémoire est configuré en mode de mémorisation 2T2R, que l'écriture d'une cellule se fait comme décrit précédemment avec des programmations 1T1R pour programmer les cellules « gauche » puis les cellules « droites » et enfin en faisant une lecture différentielle 2T2R si nécessaire pour sortir du cycle des écritures, éventuellement sans erreur si la lecture différentielle est correcte.

Avec un dispositif mémoire à double mode de mémorisation, la lecture en mode 1T1R des cellules gauches puis droites, se traduit par la production par le processeur hôte de deux adresses successives différentes, qui pourront par exemple se différentier uniquement par un bit d'adresse (signifiant ainsi « gauche » ou « droite »).

Selon une variante de réalisation, la sélection des cellules « gauches » ou « droites » des cellules différentielles peut aussi être transparente pour le processeur hôte et assurée par le contrôleur mémoire. Ainsi, le processeur hôte peut requérir une écriture à une adresse donnée et c'est le contrôleur mémoire qui va se charger de réaliser tout le procédé itératif d'écritures/lectures de vérification et qui va donc se charger de piloter les dispositifs de sélection lignes/colonnes de la matrice mémoire pour sélectionner soit les cellules gauches, soit les cellules droites dans les phases d'écriture et de lecture en 1T1R. Autrement dit, de l'extérieur du dispositif mémoire, le processeur peut ne voir que des écritures et des lectures différentielles à une adresse de sélection, et c'est le contrôleur mémoire qui réalise toutes les sous-étapes constitutives d'une opération d'écriture nécessitant le passage en mode 1T1R.

Ainsi, dans le cas où on a un dispositif mémoire qui n'a pas de double mode de mémorisation, la sélection des cellules « gauches » ou « droites » peut être gérée par le contrôleur mémoire, de façon transparente pour le processeur hôte comme expliqué précédemment.

La figure 4 représente un système général 400 permettant de mettre en œuvre les étapes d'un procédé d'écriture dans une mémoire résistive composée de cellules différentielles 2T2R selon un mode de réalisation de l'invention, qui comprend un sous-système électronique 410, aussi appelé sous-système électronique hôte ou processeur hôte, un contrôleur mémoire 420 comprenant un encodeur et décodeur pour un code correcteur d'erreur (ECC) et une mémoire résistive 2T2R 430. Le sous-système électronique hôte peut comprendre un ou plusieurs cœurs de processeur, un microcontrôleur ou un circuit logique programmable aussi appelé FPGA (acronyme de l'anglais « Field Programmable Gate Array »). En plus ou alternativement, le sous-système hôte peut correspondre à un circuit intégré ASIC (acronyme de l'anglais « Application-Specific Integrated Circuit »). Lors d'une opération d'écriture d'un mot dans une mémoire résistive telle que celle comprise dans le système de calcul 400, des bits de données de ce mot sont émis par le sous-système électronique 410 et envoyés au contrôleur mémoire 420. Les bits de données d'un mot émis par le sous-système électronique 410 sont d'abord utilisés par l'encodeur ECC, qui générera des bits de vérification qui sont ajoutés à la suite des bits de données afin de former un mot de code. Ces bits de vérification seront stockés à la même adresse dans la mémoire résistive composée de cellules différentielles 2T2R 430 que les bits de données du même mot. Ces bits de vérification pourront notamment être utilisés par un décodeur ECC pour corriger d'éventuelles erreurs de stockage d'un mot dans la mémoire résistive en mode 2T2R 430 lors de la phase de lecture. Les bits de données et les bits de vérification constituent alors un mot de code qui doit être programmé dans les cellules de la mémoire résistive 2T2R 430.

Dans l'exemple du procédé décrit en relation avec la figure 2, on réalise à l'étape 250 une lecture de vérification en mode différentiel 2T2R des cellules différentielles sélectionnées et l'on vérifie à minima que les données lues correspondent auxdites données initiales. Cela suppose que cette vérification est réalisée en interne du dispositif mémoire, par le contrôleur mémoire. Le contrôleur mémoire a alors directement accès aux données fournies par les dispositifs de lecture qui lisent les bits de données et les bits d'ECC, c'est-à-dire a accès aux bits qui sont envoyés au décodeur présent dans le dispositif mémoire pour corriger d'éventuelles erreurs avant de sortir uniquement les bits de données, éventuellement corrigés. Le contrôleur mémoire peut alors détecter des difficultés de programmation dans les bits de données ou les bits d'ECC et réaliser ainsi une identification plus précise des bits qui ont été mal programmés, pour pouvoir se focaliser ensuite sur ces uniques bits plus difficiles à programmer dans des phases d'itération de programmation.

Selon une variante de réalisation, il est possible que la dernière étape 250 soit réalisée différemment, en considérant uniquement les données sortant du décodeur ECC. Cette variante peut notamment être envisagée dans le cas où c'est le processeur hôte qui réalise la vérification finale et prend la décision finale d'accepter ou non l'écriture.

On peut également envisager une combinaison des deux variantes, à savoir une vérification du mot de code par le contrôleur mémoire avec lever d'un drapeau à destination du processeur en cas d'erreur détectée sur le mot de code, suivie d'une vérification des données lues par le processeur, qui pourra éventuellement décider de valider quand même l'écriture si les données lues sont exactes, quand bien même cela a nécessité d'utiliser le mécanisme de correction par le décodeur.

Un avantage d'utiliser une vérification du mot de code par le contrôleur mémoire est qu'il est possible de s'assurer que l'écriture a été suffisamment satisfaisante pour avoir un mot écrit qui ne nécessite pas de correction par ECC, par le décodeur. Cela permet de laisser plus de marge de correction par l'ECC pour faire face aux erreurs qui pourront s'immiscer dans la mémoire avec le temps. Néanmoins, si le programmeur de l'application exécutée par le processeur considère que les données ne seront pas conservées très longtemps, il est possible de se satisfaire d'une écriture moins « fiable », mais qui donne, lors d'une lecture ultérieure des données correctes grâce à la correction ECC. Là encore, il s'agit d'un compromis fiabilité / temps d'écriture qui peut être réglé en fonction de l'application qui est exécutée.

La présente description illustre une implémentation préférentielle de l'invention, mais qui n'est pas limitative. Des exemples sont choisis pour permettre une bonne compréhension des principes de l'invention et une application concrète, mais ne sont en rien exhaustifs et doivent permettre à l'homme du métier d'apporter des modifications et des variantes d'implémentation en conservant les mêmes principes. Ainsi par exemple, les différents procédés décrits peuvent être implémentés au sein d'un même dispositif.

## Revendications

1. Procédé d'écriture (200) d'un mot de données dans une mémoire résistive composée de cellules différentielles 2T2R comprenant chacune des premier et deuxième ensembles d'un résistor (R) et d'un transistor de sélection (T), le procédé comprenant des étapes consistant à :
- (210) générer un mot de code initial à partir de bits de données initiales et de bits de vérification générés à partir du mot de données, et initialiser un compteur de nombre de programmations, le nombre de programmations correspondant à un nombre maximum de programmations pour ledit mot dans un groupe de cellules différentielles sélectionnées ;
- (220) programmer en mode 1T1R ce mot de code initial dans la mémoire résistive, en sélectionnant les premiers ensembles 1T1R des cellules différentielles sélectionnées, puis réaliser une lecture 1T1R de vérification et incrémenter ou décrémenter le compteur de nombre de programmations ;
- (230) répéter l'étape précédente (220) tant que tous les bits du mot de code initial n'ont pas été programmés correctement et que le nombre maximum de programmations n'est pas atteint ;
- (240) inverser le mot de code initial et réinitialiser le compteur de nombre de programmations ;
- (241) programmer en mode 1T1R dans la mémoire résistive, le mot de code initial inversé à l'étape précédente (240), en sélectionnant les deuxièmes ensembles 1T1R des cellules différentielles sélectionnées, puis réaliser une lecture 1T1R de vérification et incrémenter ou décrémenter le compteur de nombre de programmations ;
- (242) répéter l'étape précédente (241) tant que tous les bits du mot de code initial inversé n'ont pas été programmés correctement et que le nombre maximum de programmations n'est pas atteint ;
- (250) réaliser une lecture de vérification en mode différentiel 2T2R des cellules différentielles sélectionnées et vérifier à minima que les données lues correspondent auxdites données initiales ; et selon le résultat de la vérification,
- (251) terminer le procédé d'écriture ou,
- (252) signaler une erreur du procédé d'écriture.

2. Procédé d'écriture (200) d'un mot de données dans une mémoire résistive composée de cellules différentielles 2T2R selon la revendication 1, dans lequel ladite lecture de vérification en mode différentiel 2T2R inclut la vérification de tous les bits du mot de code lus par rapport aux bits du mot de code initial.

3. Procédé d'écriture (200) d'un mot de données dans une mémoire résistive composée de cellules différentielles 2T2R selon l'une quelconque des revendications précédentes, dans lequel l'étape (230) consistant à répéter l'étape précédente (220), comprend les sous-étapes suivantes consistant à :
- vérifier par lecture en mode 1T1R dans la mémoire résistive s'il reste des bits de données et de vérification non programmés ; et
- s'il reste des bits non programmés et si le nombre maximum d'écritures en mémoire pour ledit mot de code initial n'est pas atteint, répéter l'étape (220) consistant à programmer en mode 1T1R ledit mot de code initial dans la mémoire résistive ; ou
- s'il ne reste pas de bits non programmés ou si le nombre maximum d'écritures en mémoire pour ledit mot de code initial est atteint, poursuivre par l'étape suivante (240).

4. Procédé d'écriture (200) d'un mot de données dans une mémoire résistive composée de cellules différentielles 2T2R selon l'une quelconque des revendications précédentes, dans lequel l'étape (242) consistant à répéter l'étape précédente (241) comprend les sous-étapes suivantes consistant à :
- vérifier par lecture en mode 1T1R dans la mémoire résistive s'il reste des bits de données et de vérification du mot de code initial inversé non programmés ; et
- s'il reste des bits non programmés et si le nombre maximum d'écritures en mémoire pour ledit mot de code initial inversé n'est pas atteint, répéter l'étape (241) consistant à programmer en mode 1T1R ledit mot de code initial inversé dans la mémoire résistive ; ou
- s'il ne reste pas de bits non programmés ou si le nombre maximum d'écritures en mémoire pour ledit mot de code initial inversé est atteint, poursuivre par l'étape suivante (250).

5. Procédé d'écriture (200) d'un mot de données dans une mémoire résistive composée de cellules différentielles 2T2R selon l'une quelconque des revendications précédentes, dans lequel l'étape (251) consistant à terminer le procédé d'écriture est effectuée si les données lues en mode 2T2R correspondent auxdites données initiales; et dans lequel l'étape (252) consistant à signaler une erreur du procédé d'écriture est effectuée si les données lues en mode 2T2R ne correspondent pas auxdites données initiales.

6. Procédé d'écriture (200) d'un mot de données dans une mémoire résistive composée de cellules différentielles 2T2R selon l'une des revendications précédentes, l'étape (220) consistant à programmer en mode 1T1R le mot de code initial dans la mémoire résistive et/ou l'étape (241) consistant à programmer en mode 1T1R le mot de code initial inversé dans la mémoire résistive comprenant des sous-étapes consistant à :
- (310) lire en mode 1T1R dans la mémoire résistive les bits à l'adresse de programmation du mot de code et comparer les bits lus à ladite adresse de programmation et les bits du mot de code à programmer, et
- (320, 340) programmer en mode 1T1R dans la mémoire résistive uniquement les bits du mot de code qui ne correspondent pas aux bits lus.

7. Procédé d'écriture (200) d'un mot de données dans une mémoire résistive composée de cellules différentielles 2T2R selon l'une quelconque des revendications précédentes, l'étape (220) consistant à programmer en mode 1T1R le mot de code initial dans la mémoire résistive ou l'étape (241) consistant à programmer en mode 1T1R le mot de code initial inversé dans la mémoire résistive, étant effectuées par un unique circuit d'écriture adapté pour configurer dans un état HRS ou LRS les cellules de la mémoire résistive.

8. Procédé d'écriture (200) d'un mot de données dans une mémoire résistive composée de cellules différentielles 2T2R selon l'une des revendications 1 à 6, l'étape (220) consistant à programmer en mode 1T1R le mot de code initial dans la mémoire résistive et/ou l'étape (241) consistant à programmer en mode 1T1R le mot de code initial inversé dans la mémoire résistive, étant effectuées par un premier circuit d'écriture uniquement adapté pour configurer dans un état HRS les cellules de la mémoire résistive et, en parallèle, par un second circuit d'écriture uniquement adapté pour configurer dans un état LRS les cellules de la mémoire résistive.

9. Procédé d'écriture (200) d'un mot de données dans une mémoire résistive composée de cellules différentielles 2T2R selon la revendication 8, l'étape (220) consistant à programmer en mode 1T1R le mot de code initial dans la mémoire résistive et/ou l'étape (241) consistant à programmer en mode 1T1R le mot de code initial inversé dans la mémoire résistive étant effectuées premièrement par le premier circuit d'écriture concernant les cellules de la mémoire résistive à programmer dans un état HRS puis étant effectuée(s) secondairement par le second circuit d'écriture concernant les cellules de la mémoire résistive à programmer dans un état LRS, ou inversement.

10. Système comprenant une mémoire résistive composée de cellules différentielles 2T2R comprenant chacune des premier et deuxième ensembles d'un résistor (R) et d'un transistor de sélection (T), et un dispositif d'écriture d'un mot de données dans la mémoire résistive, le dispositif comprenant des moyens qui sont configurés pour mettre en œuvre les étapes du procédé d'écriture selon l'une quelconque des revendications précédentes.

11. Système selon la revendication 10, dans lequel les moyens comprennent un contrôleur mémoire couplé à la mémoire résistive adapté pour mettre en œuvre l'étape de lecture de vérification en mode différentiel 2T2R du procédé d'écriture selon l'une quelconque des revendications précédentes.

12. Système selon la revendication 10 ou 11, dans lequel les moyens comprennent un processeur hôte couplé à la mémoire résistive adapté pour mettre en œuvre l'étape de lecture de vérification en mode différentiel 2T2R du procédé d'écriture selon l'une quelconque des revendications précédentes.

## Patentansprüche

1. Verfahren zum Schreiben (200) eines Datenwortes in einen resistiven Speicher, der aus 2T2R-Differentialzellen zusammengesetzt ist, die jeweils einen ersten und einen zweiten Satz aus einem Widerstand (R) und einem Auswahltransistor (T) umfassen, wobei das Verfahren die folgenden Schritte umfasst:
- (210) Erzeugen eines Startcodewortes anhand von Startdatenbits und Prüfbits, die anhand des Datenwortes erzeugt werden, und Initialisieren eines Zählers für eine Anzahl von Programmierungen, wobei die Anzahl von Programmierungen einer Höchstanzahl von Programmierungen für das Wort in einer Gruppe von ausgewählten Differentialzellen entspricht;
- (220) Programmieren dieses Startcodewortes im resistiven Speicher im 1T1R-Modus durch Auswählen der ersten 1T1R-Sätze der ausgewählten Differentialzellen, dann Durchführen einer 1T1R-Prüfleseoperation und Hochzählen oder Abwärtszählen des Zählers für eine Anzahl von Programmierungen;
- (230) Wiederholen des vorhergehenden Schritts (220), solange nicht alle Bits des Startcodewortes korrekt programmiert worden sind und die Höchstanzahl von Programmierungen nicht erreicht worden ist;
- (240) Umkehren des Startcodewortes und erneutes Initialisieren des Zählers für eine Anzahl von Programmierungen;
- (241) Programmieren des Startcodewortes, das in dem vorherigen Schritt (240) umgekehrt wurde, in dem resistiven Speicher im 1T1R-Modus durch Auswählen der zweiten 1T1R-Sätze der ausgewählten Differentialzellen, dann Durchführen einer 1T1R-Prüfleseoperation und Hochzählen oder Abwärtszählen des Zählers für eine Anzahl von Programmierungen;
- (242) Wiederholen des vorhergehenden Schritts (241), solange alle Bits des umgekehrten Startcodewortes nicht korrekt programmiert worden sind und die Höchstanzahl von Programmierungen nicht erreicht worden ist;
- (250) Durchführen einer Prüfleseoperation im 2T2R-Differentialmodus der ausgewählten Differentialzellen und mindestens Prüfen, ob die gelesenen Daten den Startdaten entsprechen; und je nach Ergebnis der Prüfung
- (251) Beenden des Schreibverfahrens oder
- (252) Signalisieren eines Fehlers beim Schreibverfahren.

2. Verfahren (200) zum Schreiben eines Datenwortes in einen resistiven Speicher, der aus 2T2R-Differentialzellen zusammengesetzt ist, nach Anspruch 1, wobei die Prüfleseoperation im 2T2R-Differentialmodus das Prüfen aller gelesenen Bits des Codewortes in Bezug auf die Bits des Startcodewortes einschließt.

3. Verfahren (200) zum Schreiben eines Datenwortes in einen resistiven Speicher, der aus 2T2R-Differentialzellen zusammengesetzt ist, nach einem der vorhergehenden Ansprüche, wobei der Schritt (230), der darin besteht, den vorhergehenden Schritt (220) zu wiederholen, die folgenden Unterschritte umfasst:
- Prüfen, durch Lesen im 1T1R-Modus aus dem resistiven Speicher, ob es noch nicht programmierte Daten- und Prüfbits gibt; und
- wenn es noch nicht programmierte Bits gibt und wenn die Höchstanzahl von Schreiboperationen in den Speicher für das Startcodewort nicht erreicht wurde, Wiederholen des Schritts (220), der darin besteht, das Startcodewort in dem resistiven Speicher im 1T1R-Modus zu programmieren; oder
- wenn es keine noch nicht programmierten Bits gibt oder wenn die Höchstanzahl von Schreiboperationen in den Speicher für das Startcodewort erreicht wurde, Fortfahren mit dem folgenden Schritt (240).

4. Verfahren (200) zum Schreiben eines Datenwortes in einen resistiven Speicher, der aus 2T2R-Differentialzellen zusammengesetzt ist, nach einem der vorhergehenden Ansprüche, wobei der Schritt (242), der darin besteht, den vorhergehenden Schritt (241) zu wiederholen, die folgenden Unterschritte umfasst:
- Prüfen, durch Lesen im 1T1R-Modus aus dem resistiven Speicher, ob es noch nicht programmierte Daten und Prüfbits des umgekehrten Startcodewortes gibt; und
- wenn es noch nicht programmierte Bits gibt und wenn die Höchstanzahl von Schreiboperationen in den Speicher für das umgekehrte Startcodewort nicht erreicht wurde, Wiederholen des Schritts (241), der darin besteht, das umgekehrte Startcodewort in dem resistiven Speicher im 1T1R-Modus zu programmieren; oder
- wenn es keine noch nicht programmierten Bits gibt oder wenn die Höchstanzahl von Schreiboperationen in den Speicher für das umgekehrte Startcodewort erreicht wurde, Fortfahren mit dem folgenden Schritt (250).

5. Verfahren (200) zum Schreiben eines Datenwortes in einen resistiven Speicher, der aus 2T2R-Differentialzellen zusammengesetzt ist, nach einem der vorhergehenden Ansprüche, wobei der Schritt (251), der darin besteht, das Schreibverfahren zu beenden, durchgeführt wird, wenn die im 2T2R-Modus gelesenen Daten den Startdaten entsprechen; und wobei der Schritt (252), der darin besteht, einen Fehler beim Schreibverfahren zu signalisieren, durchgeführt wird, wenn die im 2T2R-Modus gelesenen Daten nicht den Startdaten entsprechen.

6. Verfahren (200) zum Schreiben eines Datenwortes in einen resistiven Speicher, der aus 2T2R-Differentialzellen zusammengesetzt ist, nach einem der vorhergehenden Ansprüche, wobei der Schritt (220), der darin besteht, das Startcodewort in dem resistiven Speicher im 1T1R-Modus zu programmieren, und/oder der Schritt (241), der darin besteht, das umgekehrte Startcodewort in dem resistiven Speicher im 1T1R-Modus zu programmieren, Unterschritte umfasst, bestehend aus Folgendem:
- (310) Lesen der Bits aus dem resistiven Speicher im 1T1R-Modus an der Programmieradresse des Codewortes und Vergleichen der an der Programmieradresse gelesenen Bits und der zu programmierenden Bits des Codewortes, und
- (320, 340) Programmieren nur der Bits des Codewortes im 1T1R-Modus in dem resistiven Speicher, die nicht den gelesenen Bits entsprechen.

7. Verfahren (200) zum Schreiben eines Datenwortes in einen resistiven Speicher, der aus 2T2R-Differentialzellen zusammengesetzt ist, nach einem der vorhergehenden Ansprüche, wobei der Schritt (220), der darin besteht, das Startcodewort im 1T1R-Modus in dem resistiven Speicher zu programmieren, oder der Schritt (241), der darin besteht, das umgekehrte Startcodewort im 1T1R-Modus in dem resistiven Speicher zu programmieren, durch eine einzige Schreibschaltung durchgeführt wird, die geeignet ist, die Zellen des resistiven Speichers in einem HRS- oder LRS-Zustand zu konfigurieren.

8. Verfahren (200) zum Schreiben eines Datenwortes in einen resistiven Speicher, der aus 2T2R-Differentialzellen zusammengesetzt ist, nach einem der Ansprüche 1 bis 6, wobei der Schritt (220), der darin besteht, das Startcodewort im 1T1R-Modus in dem resistiven Speicher zu programmieren, oder der Schritt (241), der darin besteht, das umgekehrte Startcodewort im 1T1R-Modus in dem resistiven Speicher zu programmieren, durch eine Schreibschaltung, die nur geeignet ist, die Zellen des resistiven Speichers in einem HRS-Zustand zu konfigurieren, und parallel durch eine zweite Schreibschaltung durchgeführt wird, die nur dazu geeignet ist, die Zellen des resistiven Speichers in einem LRS-Zustand zu konfigurieren.

9. Verfahren (200) zum Schreiben eines Datenwortes in einen resistiven Speicher, der aus 2T2R-Differentialzellen zusammengesetzt ist, nach Anspruch 8, wobei der Schritt (220), der darin besteht, das Startcodewort im 1T1R-Modus in dem resistiven Speicher zu programmieren, oder der Schritt (241), der darin besteht, das umgekehrte Startcodewort im 1T1R-Modus in dem resistiven Speicher zu programmieren, erstens durch die erste Schreibschaltung betreffend die Zellen des resistiven Speichers, die in einem HRS-Zustand zu programmieren sind, durchgeführt wird, und dann zweitens durch die zweite Schreibschaltung betreffend die Zellen des resistiven Speichers, die in einem LRS-Zustand zu programmieren sind, durchgeführt wird/werden, oder umgekehrt.

10. System, umfassend einen resistiven Speicher, der aus 2T2R-Differentialzellen zusammengesetzt ist, die jeweils einen ersten und einen zweiten Satze eines Widerstands (R) und eines Auswahltransistors (T) umfassen, und eine Vorrichtung zum Schreiben eines Datenwortes in den resistiven Speicher, wobei die Vorrichtung Mittel umfasst, die zum Umsetzen der Schritte des Schreibverfahrens nach einem der vorhergehenden Ansprüche konfiguriert sind.

11. System nach Anspruch 10, wobei die Mittel einen Speichercontroller umfassen, der mit dem resistiven Speicher gekoppelt und dazu geeignet ist, den Schritt einer Prüfleseoperation im 2T2R-Differentialmodus des Schreibverfahrens nach einem der vorhergehenden Ansprüche umzusetzen.

12. System nach Anspruch 10 oder 11, wobei die Mittel einen Host-Prozessor umfassen, der mit dem resistiven Speicher gekoppelt und dazu geeignet ist, den Schritt einer Prüfleseoperation im 2T2R-Differentialmodus des Schreibverfahrens nach einem der vorhergehenden Ansprüche umzusetzen.

## Claims

1. Method (200) for writing a data word to a resistive memory consisting of 2T2R differential cells each comprising first and second sets of a resistor (R) and a selection transistor (T), the method comprising:
- (210) generating an initial codeword from initial data bits and check bits generated from the data word, and initialising a counter for counting a number of programming operations, the number of programming operations corresponding to a maximum number of programming operations for said word in a group of selected differential cells;
- (220) programming this initial codeword in the resistive memory in 1T1R mode, by selecting the first 1T1R sets of the selected differential cells, and then performing a 1T1R check read operation and incrementing or decrementing the counter for counting the number of programming operations;
- (230) repeating the previous step (220) for as long as all of the bits of the initial codeword have not been correctly programmed and the maximum number of programming operations has not been reached;
- (240) inverting the initial codeword and reinitialising the counter for counting the number of programming operations;
- (241) programming the initial codeword inverted in the previous step (240) in the resistive memory in 1T1R mode, by selecting the second 1T1R sets of the selected differential cells, and then performing a 1T1R check read operation and incrementing or decrementing the counter for counting the number of programming operations;
- (242) repeating the previous step (241) for as long as all of the bits of the inverted initial codeword have not been correctly programmed and the maximum number of programming operations has not been reached;
- (250) performing a check read operation in 2T2R differential mode on the selected differential cells and checking at least that the read data corresponds to said initial data; and, depending on the result of the check,
- (251) terminating the writing method or
- (252) signalling an error in the writing method.

2. The method (200) for writing a data word to a resistive memory consisting of 2T2R differential cells according to claim 1, wherein said check read operation in 2T2R differential mode includes checking all of the read bits of the codeword against the bits of the initial codeword.

3. The method (200) for writing a data word to a resistive memory consisting of 2T2R differential cells according to any one of the preceding claims, wherein the step (230) of repeating the previous step (220) comprises the following sub-steps:
- checking, by reading the resistive memory in 1T1R mode, whether there are still unprogrammed data and check bits; and
- if there are still unprogrammed bits and if the maximum number of write operations to memory for said initial codeword has not been reached, repeating the step (220) of programming said initial codeword in the resistive memory in 1T1R mode; or
- if there are not still unprogrammed bits or if the maximum number of write operations to memory for said initial codeword has been reached, continuing with the following step (240).

4. The method (200) for writing a data word to a resistive memory consisting of 2T2R differential cells according to any one of the preceding claims, wherein the step (242) of repeating the previous step (241) comprises the following sub-steps:
- checking, by reading the resistive memory in 1T1R mode, whether there are still unprogrammed data and check bits of the inverted initial codeword; and
- if there are still unprogrammed bits and if the maximum number of write operations to memory for said inverted initial codeword has not been reached, repeating the step (241) of programming said inverted initial codeword in the resistive memory in 1T1R mode; or
- if there are not still unprogrammed bits or if the maximum number of write operations to memory for said inverted initial codeword has been reached, continuing with the following step (250).

5. The method (200) for writing a data word to a resistive memory consisting of 2T2R differential cells according to any one of the preceding claims, wherein the step (251) of terminating the writing method is performed if the data read in 2T2R mode corresponds to said initial data; and wherein the step (252) of signalling an error in the writing method is performed if the data read in 2T2R mode does not correspond to said initial data.

6. The method (200) for writing a data word to a resistive memory consisting of 2T2R differential cells according to one of the preceding claims, the step (220) of programming the initial codeword in the resistive memory in 1T1R mode and/or the step (241) of programming the inverted initial codeword in the resistive memory in 1T1R mode comprising substeps of:
- (310) reading, in 1T1R mode, from the resistive memory, the bits at the programming address of the codeword and comparing the bits read at said programming address and the bits of the codeword to be programmed, and
- (320, 340) programming, in 1T1R mode, in the resistive memory, only the bits of the codeword that do not correspond to the read bits.

7. The method (200) for writing a data word to a resistive memory consisting of 2T2R differential cells according to any one of the preceding claims, the step (220) of programming the initial codeword in the resistive memory in 1T1R mode or the step (241) of programming the inverted initial codeword in the resistive memory in 1T1R mode being performed by a single write circuit adapted to configure the cells of the resistive memory in an HRS or LRS state.

8. The method (200) for writing a data word to a resistive memory consisting of 2T2R differential cells according to one of claims 1 to 6, the step (220) of programming the initial codeword in the resistive memory in 1T1R mode and/or the step (241) of programming the inverted initial codeword in the resistive memory in 1T1R mode being performed by a first write circuit adapted only to configure the cells of the resistive memory in an HRS state and, in parallel, by a second write circuit adapted only to configure the cells of the resistive memory in an LRS state.

9. The method (200) for writing a data word to a resistive memory consisting of 2T2R differential cells according to claim 8, the step (220) of programming the initial codeword in the resistive memory in 1T1R mode and/or the step (241) of programming the inverted initial codeword in the resistive memory in 1T1R mode being performed firstly by the first write circuit concerning the cells of the resistive memory to be programmed in an HRS state and then being performed secondly by the second write circuit concerning the cells of the resistive memory to be programmed in an LRS state, or vice versa.

10. A system comprising a resistive memory consisting of differential cells 2T2R each comprising first and second sets of a resistor (R) and a selection transistor (T), and a device for writing a data word into the resistive memory, the device comprising means which are configured to implement the steps of the writing method according to any one of the preceding claims.

11. The system according to Claim 10, wherein the means comprise a memory controller coupled to the resistive memory adapted to implement the step of a check read operation in 2T2R differential mode of the writing method according to any one of the preceding claims.

12. The system according to Claim 10 or 11, wherein the means comprise a host processor coupled to the resistive memory adapted to implement the step of a check read operation in 2T2R differential mode of the writing method according to any one of the preceding claims.
